# EUROPEAN PATENT APPLICATION

(11) **EP 3 117 992 A1**
(43) Date of publication of application: **18.01.2017**
(21) Application number: 15177003.9
(22) Date of filing: 16.07.2015
(51) Int. Cl.: B32B 17/10

(54) **GLASS PANEL WITH INTEGRATED ELECTRONIC DEVICE**

(71) Applicant: AGC Glass Europe, 1348 Louvain-la-Neuve (BE); Smartiworks Co Ltd, Seongnam-city 462-100 (KR)
(72) Inventor: VANDERHEIJDEN, Jana, 1500 Halle (BE); SAHYOUN, Xavier, 1500 Halle (BE); DEMEYERE, Michaël, 5380 Forville (BE); KOON, Song, 462-100 Seongnam-city (KR); MIN SANG, Lee, 462-100 Seongnam-city (KR)
(74) Representative: Chabou, Samia

(57) **Abstract**

The invention relates to a panel comprising (i) at least a first (110) outer and a second (120) inner glass sheet combined together by a means 220 of maintaining the two glass sheets at a certain distance between the two glass sheets (110, 120), (ii) an electronic device provided between the at least a first and a second glass sheet, (iii) an inner cable (150) to connect electrically the electronic device.

According to the invention, the inner glass comprises an opening arranged in the area of at least one of its extremity to allow the inner cable (150) to pass through the said opening (140).

## Description

The invention relates to a glass panel, comprising a first glass sheet and a second glass sheet. Such a glass panel can be for instance a laminated glass panel or a multiple glazing panel. More particularly, such a glass panel comprises at least one electronic device provided between the first and the second glass sheet.

### Technical Background

Laminated glass is a type of safety glass that holds together when shuttered. In the event of breaking, it is held in place by the plastics interlayer, typically of Polyvinylbutyral (PVB), between its two or more layers of glass substrate. The plastics interlayer keeps the layers of glass substrate bonded even when broken, and its high strength prevents the glass substrates from breaking-up into large sharp pieces.

Methods for manufacturing laminated glass are well-known in the window industry since decades. A so-called sandwich of the first glass substrate, the plastics interlayer and the second glass substrate is laminated in an automated laminating line by using the procedure of calendering and autoclaving. Calendering of the glass/plastic laminate means the pre-gluing of the sandwich under the action of a pressure imposed by rolls applied on either side of the glass substrates, optionally with action of heat. The final gluing of the glass substrates by a vacuum/heating cycle, which combines pressure and temperatures, takes place during the step of autoclaving, which completely removes air between the plastics interlayer and the glass substrates. The result is a clear glass laminate well known from car windscreens.

In the automotive, aviation and other industries, laminated glass panels with integrated electronic components, such as light emitting diodes (LED), or with heating facilities are known, e. g. for displaying information or for lighting purposes. For these application areas, the manufacturing of a laminated glass panel with electronic components typically comprises the steps of depositing a conductive layer on the first glass substrate, realization of electronic circuits in the conductive layer and depositing of electronic components on the conductive layer, connected to the electronic circuits. The plastics interlayer is then deposited on the conductive layer. The sandwich is obtained by the application of the second glass substrate on the plastics interlayer, which is then laminated as outlined before. In each of these applications it is necessary to furnish an electric supply to the conducting layer for supplying electrical power to the electronic devices or heating facilities. In some applications, it is also required to exchange information with the electronic components, through a data connection.

These power and data connections can be made in the following way. The cables or a junction connector are connected to the conductive layer or directly to the electronic circuits, prior deposition of the plastics interlayer. Then the assembly follows the same process of lamination as described above. The cable and/or junction connector exits the glass panel from the side edge.

This method has several disadvantages: it can complicate the assembly process because the cable or junction connector is in the way.

The cable or junction connector and the connection to the electronic component or conductive layer are very fragile. They can get easily damaged during the manufacturing process which can lead to bad contacts or complete contact losses. Furthermore, contact problems can also appear due to bad application of the connector or usage of a bad type of connector.

Even after the assembly process, the exiting cable or junction connector are located at the edge of the glazing and therefore can be easily damaged due to bad manipulations or external impacts (such as shocks during transport). Contact losses can appear during a subsequent usage of the panel of laminated glass, e.g. a local detachment of the connector and the conductive layer due to heat, or an insulation electric loss due to an application of elevated electric fields

In case of any damages to the cable or junction connector near the laminated panel or to the contact points within laminated glass panel, it is very difficult or impossible to repair the panel of laminated glass without delamination, i.e. destruction, of the panel of laminated glass.

Furthermore, the installation of the laminated glass panels in a frame, car or a façade is complicated, because special frames have to be made to fit the cable and/or junction connector and or holes need to be drilled in the frame or façade.

The same issues can occur in the case of a double glazing panel comprising LEDs such as the double glazing windows. Such a window can comprise two glass substrates, one of which being provided with a conductive coating supporting the LEDs, separated by an air gap and assembled thanks to a spacer material. A power and/or data cable is provided, generally these power and data cables are passed through a hole in the spacer. The power and data cable exit the glass pane through the silicone from the edge of the glass.

Most of the disadvantages described above are still applicable here.

The cable complicates the manufacturing process, for example. when inserting the silicone, which has to be done manually when the cable exits from the edge of the panel.

When problems arise, such as bad contacts, wrong connections, local detachment of the connector the double glazing has to be opened to repair it.

Today, façades of architectural building not only serve as a traditional wall but also as a means to enhance aesthetic look through artistic patterns and shapes. It also serves as media contents platform via various advertising and promoting measures. For example, the Korean utility model No.20-0431370 describes a plurality of glass panels forming a wall, comprising a number of LEDs on long PCB boards and having a circuit board for the operation control of the LEDs, and a supporting plate. To control and power these panels, one or more cables is exiting the glass panel from the edge of the panel. However, with such a glazing placed as a façade, some issues occur in term of soundproofing and heat protection. To bring the cables to the inside of the building, holes have to be drilled in the wall of the façade. Each panel is interconnected with each other through the control boxes within the wall of the façade. The holes in the wall cause the soundproofing and heat protection issues.

In other words, the installation of a glass panel comprising an electronic device and more particularly LEDs requires to secure a couple of holes into the wall of the façade for cabling the said glass panels resulting in its deformation and also affecting the overall safety of the structure. Furthermore, to insure the impermeability to water and dust, the holes have to be caulked resulting in additional cost.

Accordingly, it is the object of the invention to provide a glass panel with a cable for supplying electrical power or data to the glass panel, wherein the cable is easy to place without damaging it and/or damaging the structure that support the said glass panel and particularly where such a glass panel is used as a façade's panel.

Thus, one of the purpose of the present invention is to provide a glass panel comprising an electronic device and particularly LEDs that minimizes the deformation of the façade during its installation while enabling the cabling in the process. Furthermore, one object of the present invention is to propose a glass panel comprising an electronic device and particularly LEDs, and cabling integrated into an unified structure allowing easy installation as well as providing a glass panel insuring the impermeability to water and protection against dust and heat.

This object is addressed by a panel comprising:
a. at least a first outer and a second inner glass sheet combined together by a means of maintaining the two glass sheets at a certain distance between the two glass sheets,
b. an electronic device provided between the at least a first and a second glass sheet
c. an inner cable to connect electrically the electronic device.

According to the invention, the inner glass comprises an opening arranged in the area of at least one of its extremities to allow the inner cable to go through said opening (140).

According to the invention, the inner glass sheet comprises an opening allowing the inner cable to go through the said opening which is a cutout of at least one of the extremities of the inner glass sheet.

Furthermore, in another embodiment of the present invention, the inner glass sheet comprises an opening arranged in the area of a corner of the inner glass sheet and preferably in the lower part of the inner glass sheet.

Thus, a small part, in this case a corner of the inner glass is cutout and the cable could easily go through it from the interior of the glass panel to be connected to an external power source and/or data source without damaging the cable, by folding it for example and without damaging the support as for example a façade.

Furthermore, the installation and particularly the connection to a power source and data source, of the glass panel according to the present invention to a support such as a façade, is simplified. Thus, the modifications of support and particularly a façade, of the glass panel according to the invention are minimized since cables or wires from (or to) the interior of the glass panel go through a cut-out part of the inner glass. The manufacturing process is also simplified, for the double glazing panel, the silicone placement can be done automatically as the cable is not in the way.

According to one embodiment of the present invention, the inner glass sheet comprises an opening, allowing the inner cable to go through the said opening, which is a cut-out and the shape of the cut-out is triangular, C-shape or U-shape; or that the opening is a circular hole.

According to one embodiment of the present invention, the glass panel is an insulated glazing panel and wherein the at least a first and a second glass sheets are separated by a spacer disposed between the at least first and second glass sheets and extend along the periphery of the glass sheets.

According to another embodiment of the present invention, the spacer disposed between the at least first and second glass sheets and extends along the periphery of the glass sheets has a rectangular shape or may follow the same shape as the inner glass sheet with the cut-out. Indeed, in the area of the cut-out of the inner glass, the spacer may follow the shape of the cutout in order to correctly insure the adhesion of the first and the second glass sheet to the spacer.

According to another embodiment of the present invention, that the cut-out part of the inner glass sheet is filled with an insertion piece having the shape of said opening. In the case of an insulated glass unit (IGU), the insertion of such as piece presents an advantage since an IGU is generally completely rectangular, such that it fits standard frames.

According to a preferred embodiment of the present invention, the glass panel according to the present invention is placed on a façade of a building.

According to the invention, the outer glass sheet means the glass which is in contact with the exterior side and the inner glass sheet means the glass which is in contact with the interior side.

According to another embodiment, the panel according to the present invention in that the panel is a laminated glazing panel wherein the at least first and second glass sheets are separated by at least one interlayer material.

According to the present invention, the panel comprises an electronic device is chosen among a light emitting device, a switchable film such as an Electrochromic film, photovoltaic cells, display...

According to a preferred embodiment of the present invention, the glass panel comprises as an electronic device a light emitting device such as a plurality of LEDs provided on at least one of the inner faces of at least a first and second glass sheets. Thus, the glass panel may be used to deliver a message, an advertisement, or purely aesthetic. It is further preferred that a plurality of LEDs are provided, wherein the plurality of LEDs are either electrically connected in parallel or in series by means of a plurality of inner conductive layers, and wherein the electric components are preferably electrically connected to an inner conductive layers by means of gluing and/or soldering.

A glass panel comprising a plurality of LEDs disposed between the first of the second glass sheets are well known from the prior art.

In another embodiment of the present invention, the inner glass sheet is smaller than the outer glass to facilitate the fixation of the panel to a façade.

According to another embodiment of the present invention, a cable connector to connect the electronic device is provided in the opening (cutout part) to facilitate the plug-in.

Thus, the cable has only to be plugged at installation, which facilitates the installation and transport of the glass panes. Furthermore, this facilitates the manufacturing process as we don't have a cable attached to the glass during IGU assembly & silicone filling. The cable can also be delivered in batch and be cut during installation in preferred sizes, as compared to supplying the glass pane with cable already attached.

The term "glass", within the meaning of the invention, is understood to mean a completely amorphous material sheet of glass, thus excluding any crystalline material, even partially crystalline material (such as, for example, glass-crystalline or glass-ceramic materials).

The glass according to the invention is made of glass which can belong to various categories. The glass can thus be a glass of soda-lime-silica, aluminosilicate or borosilicate type, and the like. Preferably and for reasons of lower production costs, the glass sheet according to the invention is a sheet of soda-lime-silica glass.

The glass sheet according to the invention can be a glass sheet obtained by a floating process, a drawing process, a rolling process or any other process known to manufacture a glass sheet starting from a molten glass composition. According to a preferred embodiment according to the invention, the glass sheet is a float glass sheet. The term "float glass sheet" is understood to mean a glass sheet formed by the float glass process, which consists in pouring the molten glass onto a bath of molten tin, under reducing conditions. A float glass sheet comprises, in a known way, a "tin face", that is to say a face enriched in tin in the body of the glass close to the surface of the sheet. The term "enrichment in tin" is understood to mean an increase in the concentration of tin with respect to the composition of the glass at the core, which may or may not be substantially zero (devoid of tin).

The glass sheet according to the invention can have varied and relatively small sizes. It can, for example, have sizes ranging from 150mm by 150mm up to 3000mm by 1600mm.

The glass sheet according to the invention can have a thickness varying between 0.1 and 25 mm. Advantageously, in the case of the application of touch panels, the glass sheet according to the invention can have a thickness varying between 0.1 and 6 mm. Preferably, in the case of the touch screens application, for reasons of weight, the thickness of the glass sheet according to the invention is from 0.1 to 2.2 mm.

According to another embodiment of the present invention, an anti-reflective coating may be provided on the surface of glass sheet.

The object of the invention is further addressed by a method for manufacturing a panel, comprising the steps of providing a first outer glass sheet and a second inner glass sheet, wherein the opening in the second inner glass sheet is previously cut out or drilled before the assembly of the first and the second glass sheets.

The method for manufacturing a panel of laminated glass according to the invention is advantageous, since it allows to simplify the installation of the panel according to the invention to a support such as a façade.

These and other aspects of the invention will be apparent from and elucidated with reference to the embodiments described hereinafter.

### Brief Description of the Drawings

***Fig. 1*** schematically shows a panel of insulated glass unit installed on a façade wall structure according to prior art in a partial cross section view,
***Fig. 2*** schematically shows a panel of insulated glass unit and a partial façade wall according to a preferred embodiment of the invention in a perspective side view, as seen from the exterior of the building structure;
***Fig. 3*** schematically shows a panel of insulated glass unit according to a preferred embodiment of the invention in a partial cross section view;
***Fig. 4a*** schematically shows a panel of insulated glass unit according to a preferred embodiment of the invention in partial side and cross section view, as seen from the interior of the building
***Fig. 4b*** schematically shows a panel of insulated glass unit according to a preferred embodiment of the invention in a perspective side view, as seen from the exterior of the building structure
***Figs. 5 to 8*** schematically shows some examples of a panel of insulated glass unit according to a preferred embodiment of the invention.
**Fig. 9** schematically shows a panel of insulated glass unit according to a preferred embodiment of the invention in a perspective side view, as seen from the interior of the building structure

### Detailed Description of the illustrative embodiments

The drawings described are only schematic and are non-limiting. In the drawings, the size of some of the elements may be exaggerated and not drawn on scale for illustrative purposes. The mere fact that certain measures are recited in mutually different dependent claims does not indicate that a combination of these measured cannot be used to advantage. Any reference signs in the claims should not be construed as limiting the scope.

Where the term "comprising" is used in the present description and claims, it does not exclude other elements or steps. Where an indefinite or definite article is used when referring to a singular noun e.g. "a" or "an", "the", this includes a plural of that noun unless something else is specifically stated.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

The invention has been illustrated and described in the case of a panel of an insulated glass unit (IGU), nevertheless the invention can also be applied in all kind of glass panel comprising at least two glass substrates, for instance in a laminated glass panel, triple glazing... In the case of a laminated glass panel according to the invention, the means of maintaining the first and the second glass sheets is at least one thermoplastic interlayer.

As a part of a wall installed at the facade of building structure, the panel 100 according to the present invention comprises
a. at least a first 110 outer and a second 120 inner glass sheet combined together by a means 220 of maintaining the two glass sheets at a certain distance between the two glass sheets 110, 120,
b. an electronic device 130 provided between the at least a first 110 and a second glass sheet 120
c. an inner cable 150 to connect electrically the electronic device.

According to the invention, the inner glass 110 comprises an opening 140 arranged in the area of at least one of its extremity to allow the inner cable 150 to pass through the said opening 140.

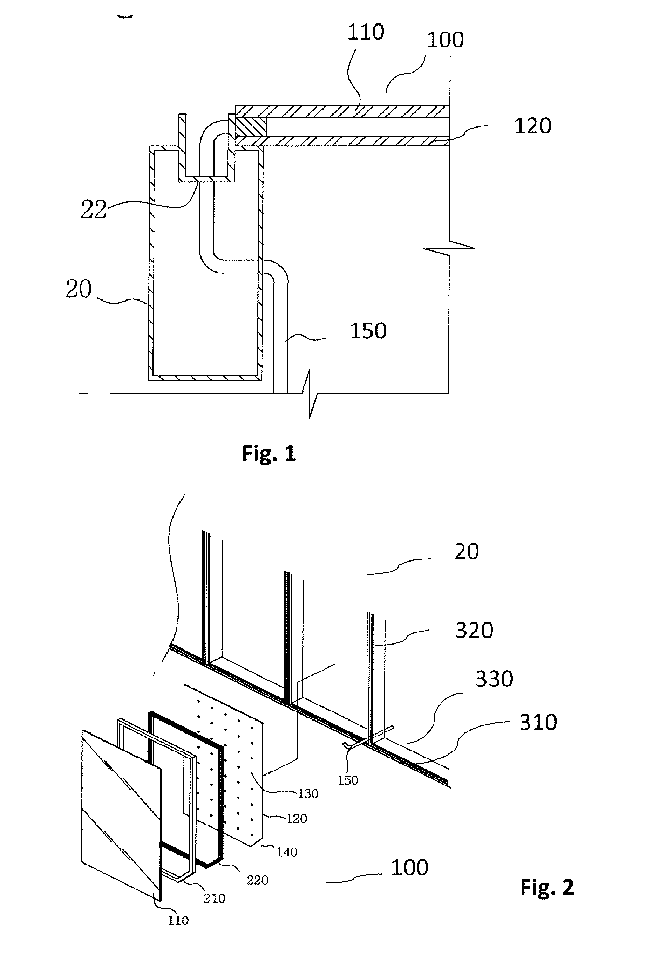

According to the **Fig.1**, a double glazing 100 is shown with a spacer 220 to maintain the two glass sheets at a certain distance. The spacer is pierced and the cable 150 exits the glazing through the spacer from the edge of the double glazing 100. The cable then passes through a hole (22) in the wall 300 of the façade. This figure shows prior art to this invention.

According to the **Fig.2**, the first outer glass sheet 110 and the second inner glass sheet 120 are separated by a spacer 220 that maintain the two glass sheets at a certain distance. A plurality of LEDs 130 is placed on the inner face of the inner glass sheet 120. The spacer 220 and the silicone 210 surrounding the spacer prevent the leakage of air/gas out of the double glazing allows to link together the outer 110 and the inner 120 glass sheets. Spacers, used to combine together at least two glass sheets, and ways to fix them to glass sheets are well known and are not more detailed in the present invention. A triangular cutout 140 of the inner 120 glass sheet is used to pass the inner cable 150 from the interior of the glass panel through the opening to be connected to the interior of the building. This cutout can also be U or C shaped. The inner cable 150 comprises various power/data cables arranged to power and control the LEDs 130 and PCB boards (not shown) attached to the inner glass sheet 120.

The spacer 220 and silicone 210 follow the same shape as the inner 120 glass sheet with the cutout 140.

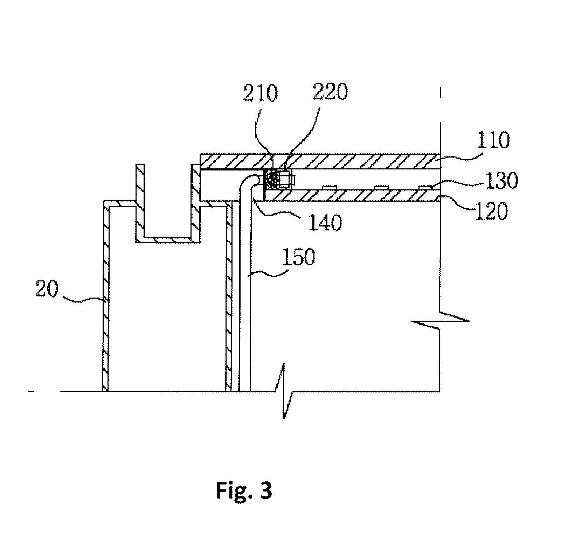

According to the ***Fig.3***, the first outer glass sheet 110 and the second inner glass sheet 120 are separated by a spacer 220 that maintain the two glass sheets at a certain distance. A plurality of LEDs 130 is placed on the inner face of the inner glass sheet 120. The spacer 220 and the silicone 210 surrounding the spacer prevent the leakage of air/gas out of the double glazing allows to link together the outer 110 and the inner 120 glass sheets. A cutout 140 of the inner 120 glass sheet is used to pass the cable 150 to the inside of the double glazing and then through a hole in the spacer 220. No hole in the wall 20 of the façade is required.

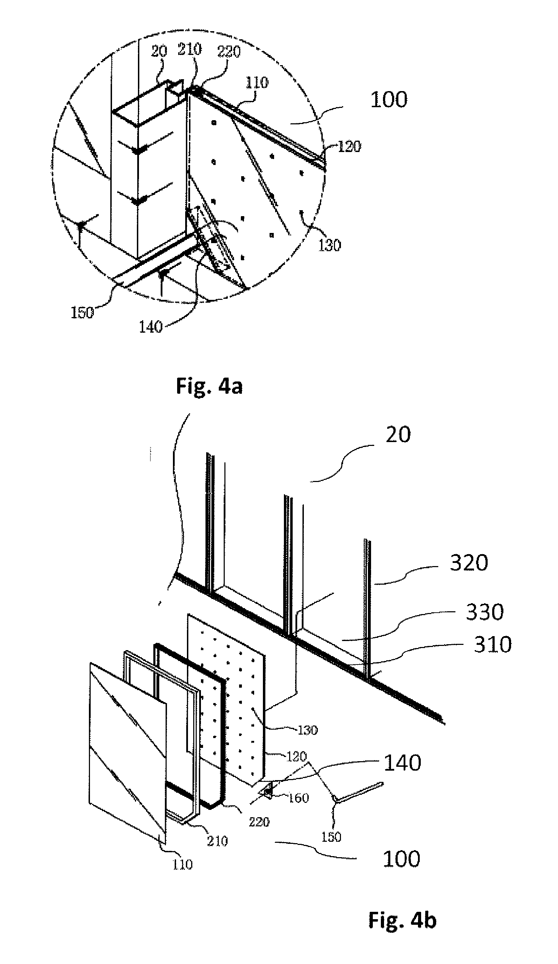

According to ***Fig. 4a and 4b***, the first outer glass sheet 110 and the second inner glass sheet 120 are separated by a spacer 220 that maintain the two glass sheets at a certain distance. A plurality of LEDs 130 is placed on the inner face of the inner glass sheet 120. The spacer 220 and the silicone 210 surrounding the spacer prevent the leakage of air/gas out of the double glazing allows to link together the outer 110 and the inner 120 glass sheets. A triangular cutout 140 of the inner 120 glass sheet is used to pass the inner cable 150 from the interior of the glass panel through the opening to be connected to the interior of the building. The spacer 220 and silicone 210 follow the same shape as the inner 120 glass sheet with the cutout 140. The cutout part 140 of the inner glass sheet is filled with an insertion piece 160 having the shape of said opening. The cable pass through a hole in this insertion piece 160. The insertion of such a piece is used to retain the rectangular form of the double glazing to be compatible with standard frames.

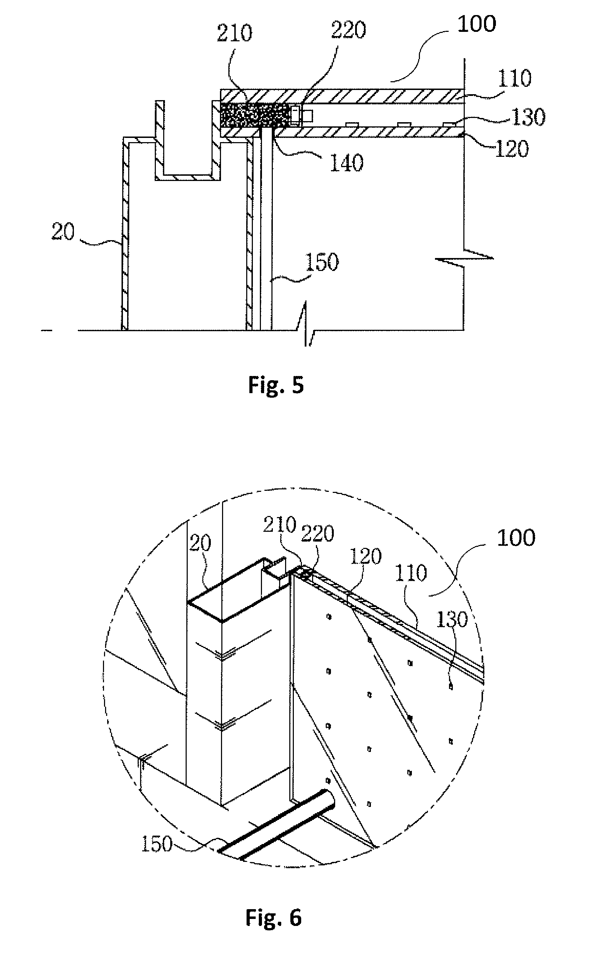

According to ***Fig. 5 and 6***, the first outer glass sheet 110 and the second inner glass sheet 120 are separated by a spacer 220 that maintain the two glass sheets at a certain distance. A plurality of LEDs 130 is placed on the inner face of the inner glass sheet 120. The spacer 220 and the silicone 210 surrounding the spacer prevent the leakage of air/gas out of the double glazing allows to link together the outer 110 and the inner 120 glass sheets. A hole 140 is drilled in the inner 120 glass sheet to pass the inner cable 150 from the interior of the glass panel through the hole to the interior of the building.

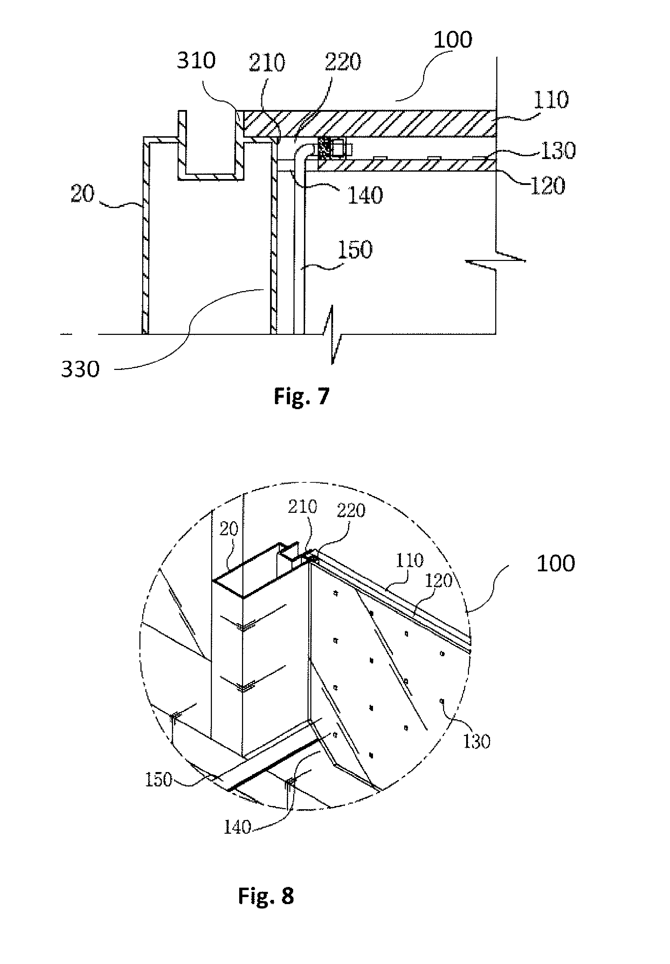

According to ***Fig. 7 and 8***, the first outer glass sheet 110 and the second inner glass sheet 120 are separated by a spacer 220 that maintain the two glass sheets at a certain distance. A plurality of LEDs 130 is placed on the inner face of the inner glass sheet 120. The spacer 220 and the silicone 210 surrounding the spacer prevent the leakage of air/gas out of the double glazing allows to link together the outer 110 and the inner 120 glass sheets. A triangular cutout 140 of the inner 120 glass sheet is used to pass the inner cable 150 from the interior of the glass panel through the opening 140 to be connected to the interior of the building. The inner glass sheet 120 is smaller than the outer glass sheet 110 to facilitate fixation of the glass panel to the wall (20) structure. The outer glass sheet 110 is then attached to the outer part 310 of the wall structure 20, while the inner glass sheet 120 will be attached to the inner wall structure 330. This fixation method allows to minimize the gap between the façade wall and the glass panel and also increases the protection against moisture and dust. After passing the inner cable 150 through the opening 150, the spacing between the opening 150 and the inner cable 150 may be sealed with an insulator made out of foam resinor other types, for protection against humidity penetration and gas losses.

As stated above, the panel according to the invention does not alter the structure of the building 20 while enabling the installation of the inner cable.

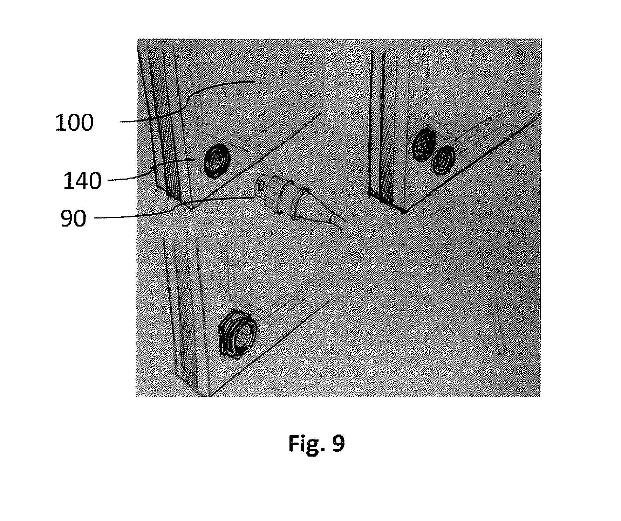

According to ***Fig. 9***, the first outer glass sheet 110 and the second inner glass sheet 120 are separated by a spacer 220 that maintain the two glass sheets at a certain distance. The spacer 220 and the silicone 210 surrounding the spacer prevent the leakage of air/gas out of the double glazing allows to link together the outer 110 and the inner 120 glass sheets. A hole 140 is drilled in the inner 120 glass sheet to pass the a cable connector through the opening. This cable connector allows easy plug-in of a cable to the glass panel. Different cable connectors are shown in the figure.

## Claims

1. Panel comprising:
a. at least a first (110) outer and a second (120) inner glass sheet combined together by a means (220) of maintaining the two glass sheets at a certain distance between the two glass sheets (110, 120),
b. an electronic device (130) provided between the at least a first (110) and a second glass sheet (120),
c. an inner cable (150) to connect electrically the electronic device
**characterized in that** the inner glass (120) comprises an opening (140) arranged in the area of at least one of its extremities to allow the inner cable (150) to pass through the said opening (140).

2. Panel (100) according to claim 1, **characterized in that** the opening (140) is arranged in the area of a corner of the inner glass sheet (120) and preferably in the lower part of the inner glass sheet (120).

3. Panel (100) according to claim 1 or 2, characterized that the opening (140) is a cut-out and the shape of the cut-out is triangular, C-shape or U-shape; or that the opening (140) is a circular hole.

4. Panel (100) according to any of preceding claims, **characterized in that** the panel is placed on a façade of a building.

5. Panel (100) according to claim 4, **characterized in that** the cut-out (150) is filled with an insertion piece having the shape of said opening (150).

6. Panel (100) according to any of preceding claims is an insulated glazing panel and wherein the at least a first (110) and a second (120) glass sheets are separated by a spacer (220) disposed between the at least first and second glass sheets and extends along the periphery of the glass sheets (110, 120).

7. Panel (100) according to claim 1 to 6, **characterized in that** the spacer (220) has a rectangular shape or follows the same shape as the inner (120) glass sheet with the cut-out (140)

8. Panel (100) according to anyone of claims 1 to 5, **characterized in that** the panel is a laminated glazing panel wherein the at least first (110) and second (120) glass sheets are separated by at least one interlayer material (220).

9. Panel (100) according to claims 1 to 8, **characterized in that** the inner glass is smaller than the outer glass to facilitate the fixation of the panel to a façade.
Panel according to any of claims 1 to 9, **characterized in that** a cable connector (90) to connect the electronic device is provided in the opening (140) to facilitate the plug-in.

10. Panel (100) according to any of claim 1 to 10, **characterized in that** the electronic device is chosen among a light emitting device, Electrochromic film, photovoltaic cells, display.

11. Panel (100) according to claim 11, **characterized in that** the light emitting device is a plurality of LEDs (130) provided on at least one of the inner faces of at least a first (110) and second (120) glass sheets.

12. Method for manufacturing a panel (100), comprising the steps of providing a first (110) outer glass sheet and a second inner (120) glass sheet, wherein the opening (140) in the second inner (120) glass sheet is previously cut out or drilled before the assembly of the first (110) and the second (120) glass sheets.
